# EUROPEAN PATENT APPLICATION

(11) **EP 2 706 559 A1**
(43) Date of publication of application: **12.03.2014**
(21) Application number: 12306091.5
(22) Date of filing: 11.09.2012
(51) Int. Cl.: H01L 21/48

(54) **Method for manufacturing a circuit, circuit, method and computer program for adjusting a component**

(71) Applicant: Alcatel Lucent, 75007 Paris (FR)
(72) Inventor: Blanke, Gero, 71254 Ditzingen (DE)
(74) Representative: 2SPL Patentanwälte

(57) **Abstract**

Embodiments provide a method for circuit manufacturing, a circuit, a method, and a computer program for adjusting a component in a circuit. The method for manufacturing a circuit 20 comprises mounting 10 of an adjustable component 30 of the circuit 20, and 3D-printing 12 a material 35 to adjust the component.

## Description

Embodiments of the present invention relate to circuit manufacturing, a circuit, a method, and a computer program for adjusting a component in a circuit.

### Background

Demands for enhanced circuit technologies are steadily increasing. Components of enhanced circuits become smaller and smaller, more and more functionalities are integrated in smaller and smaller circuits. For example, more and more radio frequency components are integrated in devices nowadays, to enable compatibility to various wireless systems and applications. Especially in network technologies, where also optical component are integrated and established, the size of the components and the degree of integration is steadily growing. Moreover, the use of micro-mechanical devices such as micro-mechanical acceleration sensors, piezoelectric, gyroscopes, etc., is well-established.

All of these components need to be manufactured in high precision in order to fulfill their tasks in the later circuits. For example, optical devices such as reflectors or deflectors have to be very precise in order to meet the requirements of the respective systems. For example, the surface geometry of such reflectors has to be very precise to provide the correct reflection angles, when mounted into the respective surfaces. Other examples are Radio Frequency (RF) components, for which there are also high geometric requirements, especially when taking into account that frequencies of such systems are steadily increasing. For example, some wireless applications operate at frequencies as high as 5 GHz and even higher, i.e. at wavelengths of just a few cms. As the wavelength determines the geometrics of many of these components, a higher precision is required the higher the frequency the system operates on.

Moreover, conventional systems underlie production inaccuracies, material variance, environmental conditions and aging. That is to say, not every component is exactly like the other, and variances in the according circuits are even higher, since the individual variances of the components superimpose. Furthermore, as the circuits and their components age, deviations occur, which can then be remedied by either maintenance efforts or by replacement of the respective components or circuits. The maintenance efforts often require that circuits are removed, measurement are taken at the circuits, and corresponding adjustments are carried out manually to de-age or re-adjust deviated or off-tuned components.

### Summary

Embodiments are based on the finding that properties of circuit components can be adjusted using material, which can be provided by a 3-Dimension (3D) printer or by removing material using a material removal device. The material may be removed by means of chips, shavings, swarfs, etc. i.e. the material may be removed in pieces of basically one-dimensional shapes. In some embodiments the material may be removed in in layers, i.e. in pieces of basically two-dimensional shapes. In other embodiments pieces of basically three dimensional shapes may be removed. Overall, a three-dimensional section of material may be removed, which can be carried out by a sequence of removing multiple pieces, which may have different shapes, such that the 3D section is formed. That is to say that inaccuracies which occur for example during manufacturing of components for electrical or optical circuits may be adjusted or compensated during the manufacturing of a circuit by applying extra material using a 3D printer. For example, in wireless communications circuits are manufactured for mobile devices such as cell phones, mobile phones, USB sticks, PDAs etc., and for base station transceivers, such as a NodeB of the Universal Mobile Telecommunication System (UMTS) or the enhanced NodeB (eNodeB) in the Long-Term Evolution system (LTE). Hence, during the manufacturing the components of circuits for base stations or mobile transceivers may be adjusted. In other words, RF component performance inaccuracies may be compensated by electronic and/or mechanic adjustments during assembly and test. This can be achieved by applying or removing extra material.

During operation the 3D printer or a material removal device may be implemented in a circuit, such that adjustments may also be carried out during operation or when the circuit has been in operation for some time. For example, accessibility of tower mounted components for maintenance works is an impediment. Embodiments may provide the advantage that this impediment can be overcome, by implementing according devices, i.e. a 3D printer with appropriate printing materials and/or a material removal device, in the respective circuit, such that the tower top does not have to be accessed any more. It is a further finding that the necessity for such maintenance work can often not be determined in advance. Moreover, local presence of maintenance personnel and interruption of service may be reduced or avoided by embodiments.

Embodiments may reduce the necessity to access such circuits, especially after they have been in operation for extended times, such as a year, for example. In other words, embodiments may provide such circuits comprising a 3D printer or a material removal device for adjusting the components after aging or deviation due to other effects.

Embodiments therefore provide a method for manufacturing a circuit. The method comprises mounting of an adjustable component of the circuit and 3D printing a material to adjust a component. Here and in the following the term 3D printing is to be understood as a process of adding material, i.e. generating a three-dimensional object from said material, in the circuit. For example, a certain material, which will be detailed subsequently, may be used to lay down one or more layers in order to form or generate a potentially three-dimensional structure. Hence, the term 3D printer may also be understood as a material printer, being operable to generate a structure from a certain printing material. Moreover, the term adjustable component corresponds to a component of the circuit, which has at least one property which can be changed using the material. Such properties may be of a geometrical nature, i.e. the orientation or even the size of the component may be changed using the 3D printing material. Another property may be an electrical property, such as an inductivity or capacity. In such embodiments printing material may be used which has these electrical properties. For example, a dielectric may be used. Such dielectric may be fluid in the beginning, but then the 3D printer or the process of 3D printing may foresee curing or hardening the dielectric.

In further embodiments the method may comprise a step of measuring the adjustable component in the circuit to obtain a measurement result, and adjusting the component based on the measurement result using the 3D printing. In other words, after a first mounting of the components into the circuit, certain measurements may be carried out on the circuit. Based on these measurements, the circuit may be adjusted, i.e. some performance measures may be improved. Said adjusting of the component can be based on the 3D printing.

In further embodiments, the mounting of the adjustable component may correspond to mounting the adjustable component on a printed circuit board. In other words, embodiments may provide a method for manufacturing printing circuit boards and for mounting the respective components thereon. The components may then be measured and adjusted using the 3D printing.

In some embodiments the adjustable component is a capacitor comprising a dielectric and the material corresponds to additional dielectric influencing the capacity of the capacitor. In other words, the capacitor may be mounted into the circuit, and its capacity may be adjusted. In some embodiments measurements are taken and the additional dielectric is printed into the capacitor to enhance its capacity in order to adjust the capacitor or the overall circuit. In other embodiments dielectric may be removed from the capacitor. Therefore, the method may comprise the step of removing the dielectric from the capacitor as well. Moreover, the method may comprise the step of 3D printing a housing for the component. For example, after printing a dielectric to the capacitor, another material, such as plastic material or synthetic material, may be used to also print a housing or seal the component, for example, the capacitor.

In other embodiments, the 3D printing may comprise adjusting a geometrical orientation of the component or adjusting surface properties of the component. For example, if the component is an optical reflector, the orientation of the surface may be adjusted or fine-tuned, in order to direct the reflection into the desired direction. In such embodiments, the printing material may be reflective, i.e. it may reflect light or any electromagnetic wave. In other embodiments, the surface of the component may be reflective and the printing material may be filling material which is printed underneath or on a side of the component, in order to geometrically adjust the component and therewith its surface to achieve the desired reflection angle. Again in some embodiments the method may further comprise removing material to adjust a component. Similar to what was said above, material may be removed in order to adjust the surface of the component. In yet another embodiment the surface of a component may be adjusted, such that a reflection is reduced.

For example, a certain part of the reflective surface of the component may be covered with a covering material, in order to make the surface reflect less. In other embodiments, the shape or size of the reflecting surface of the component may be adjusted, by covering certain areas with the covering material using the 3D printing. In another embodiment, the 3D printing may be used to diffuse a reflection from the surface. For example, a random or pseudo-random pattern of the covering material may be printed onto the surface, in order to diffuse or diffract the reflection. For example, in some embodiments, the reflecting surface may be diffused in order to hide the surface, i.e. to make the surface invisible to a receiver or an observer. For example, such a technique may be used in radar applications, where some reflectors are supposed not to be observed by a radar receiver. Surfaces may then be covered with 3D printing material in order to diffract or diffuse the reflection. That is to say in embodiments the 3D printing may comprise adjusting reflection properties of a component. The adjusting may comprise reducing at least partly a reflection of the component.

Embodiments may further provide a circuit comprising a 3D printer operable to use a material to adjust a component after deviation of a property of a component has been determined and/or comprising a device operable to remove the material from the circuit to adjust the component after the deviation of the component's property has been determined. In other words, in embodiments, the circuit may comprise a 3D printer or a material removal device. The material removal device may correspond to a mill, a mortizer, a rotary cutter, a slider, any tool to remove splints or blades from the material. In line with what was said above, the component's property may be an electrical, a mechanical, a magnetic, an optical, etc. property. The deviation may be due to aging or environmental conditions, production inaccuracies, material variance, etc.

In embodiments the component can be a capacitor, the printing material can then be a dielectric and the capacity can be the property of the component which is adjusted, in line with what was said above. Correspondingly, the component can be a reflector, such as an optical or an electrical reflector, and the material can be a reflecting or covering material, wherein a reflection property of the component is adjusted. This adjusting may correspond to a reduction of the reflection, a shaping of the reflection, a diffusion of the reflection, an improvement of the reflection, etc.

In some embodiments the circuit may comprise means for determining the deviations. The means for determining the deviations can be any determiner, such as any circuitry which allows to determine such deviations. In some embodiments measurements may be taken on the components. With respect to radio frequency components, for example, a standing wave ratio may be determined, and a mistuning may be determined from the standing wave ratio. Generally, in embodiments the means for determining can be operable to determine deviations on radio frequency components or on optical components after the circuit has been in an operating state. That is to say, that after the manufacturing process the circuit may be operated, i.e. mounted somewhere in the field. For example, tower-top base stations may comprise such a circuit. After a while, when environmental and aging effects emerge, such deviations may be detected. Embodiments may then provide the advantage that the circuit may readjust components that are already comprised in the circuit. That way, expensive and complicated maintenance procedures can be avoided or reduced. In an optical application, diffused or diffracted light may be measured using a photosensor. In electrical applications, aside from the standing wave ratio, leaking currents may be determined. In other applications, a temperature may be measured, where the temperature of the components may provide insight on how much power is converted into heat, i.e. the temperature may provide information on the power loss at a component.

In other embodiments, the component may be a mechanical component. The material may then be a filling material and a fitting of the mechanical component may be adjusted. In other words, due to any effects, a mechanical component may lose its fitting, i.e. gaps may occur due to aging or environmental effects.

Such gaps may be filled using an according filling material. In further embodiments, the circuit may comprise means for determining a temperature of the component. The means for determining the temperature can be any temperature determiner. For example the means for determining the temperature may comprise a temperature sensor and according circuitry to derive information on the temperature. The circuit can be further operable to adjust a component based on a temperature. In other words, as it has been mentioned above, the temperature may be used as a measure for the deviation. In other embodiments, the temperature may be taken into account, when determining when to adjust a component. In other words, the temperature may determine when to use the 3D printer to fill in additional material. For example, certain gaps may be biggest at high temperatures, other ones may be smallest at high temperatures. In some embodiments, the circuit is operable to fill such a gap at a high temperature, or at a low temperature, respectively.

Embodiments further provide a base station transceiver of a mobile communication system with a circuit as described above.

Embodiments further provide a method for adjusting a deviation of a component of a circuit. The method comprises determining the deviation of the component. The method further comprises adjusting the component by adding material using a 3D printer and/or adjusting the component by removing material using a removal device.

Embodiments further provide a computer program having a program code for performing one of the above methods, when a computer program is executed on a computer or processor.

In some embodiments, the performance of radio frequency components and radio frequency systems can be measured electronically. This can occur during assembly and test as well as during operation. In some embodiments, the measurements may even be taken without the need of local presence or interruption of service. If deviations are detected which can be solved mechanically, in some embodiments this can be done by applying correcting material from the 3D printer. The material can either be applied directly to a component and correct the performance of the component by modification of its surface or electrical characteristics. In other embodiments it can be used to produce mechanical parts that change the position or orientation of a component such that the wanted improvement is achieved. During assembly and test this can be done using external, dedicated 3D printers. During operation miniaturized 3D printers may be integrated in the radio frequency system. Control of the printers can be done electronically.

Embodiments may therewith provide the advantage that maintenance expenses and efforts can be reduced.

### Brief Description of the Figures

Some other features or aspects will be described using the following non-limiting embodiments of apparatuses and/or methods and/or computer programs by way of example only, and with reference to the accompanying Figures, in which
Fig. 1 illustrates a block diagram of an embodiment of a method for manufacturing a circuit;
Fig. 2 shows an embodiment of a circuit;
Fig. 3 shows another embodiment with an adjustment of a reflector;
Fig. 4 shows an embodiment with an adjustment of a reflection surface;
Fig. 5 shows an embodiment with an adjustable capacitor; and
Fig. 6 shows a block diagram of an embodiment of a method for adjusting a deviation.

### Description of Some Embodiments

Various embodiments will now be described in more detail with reference to the accompanying drawings. In the figures, the thicknesses of lines, layers and/or regions may be exaggerated for clarity.

Accordingly, while embodiments are capable of various modifications and alternative forms, embodiments thereof are shown by way of example in the figures and will herein be described in detail. It should be understood, however, that there is no intent to limit embodiments to the particular forms disclosed, but on the contrary, embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

In the following description some components will be displayed in multiple figures carrying the same reference signs, but may not be described multiple times in detail. A detailed description of a component may then apply to that component for all its occurrences.

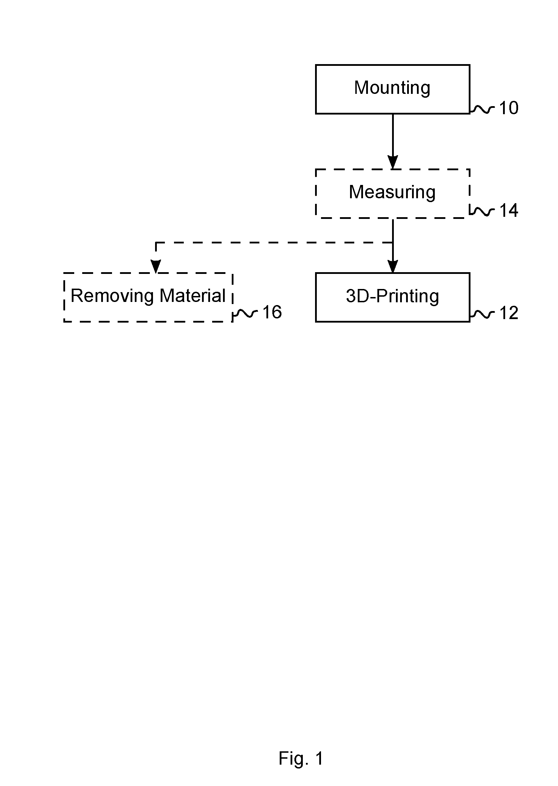

Fig. 1 illustrates a block diagram of an embodiment of a method for manufacturing a circuit. The method comprises mounting 10 of an adjustable component of the circuit and 3D printing 12 a material to adjust the component. The embodiment depicted in Fig. 1 further comprises the optional step of measuring 14 the adjustable component in the circuit to obtain a measurement result. The adjusting of the component is then based on the measurement result using the 3D printing 12. Fig. 1 also illustrates the optional step of removing material 16. In some of the following embodiments, the mounting 10 of the adjustable component corresponds to mounting the adjustable component on a printed circuit board.

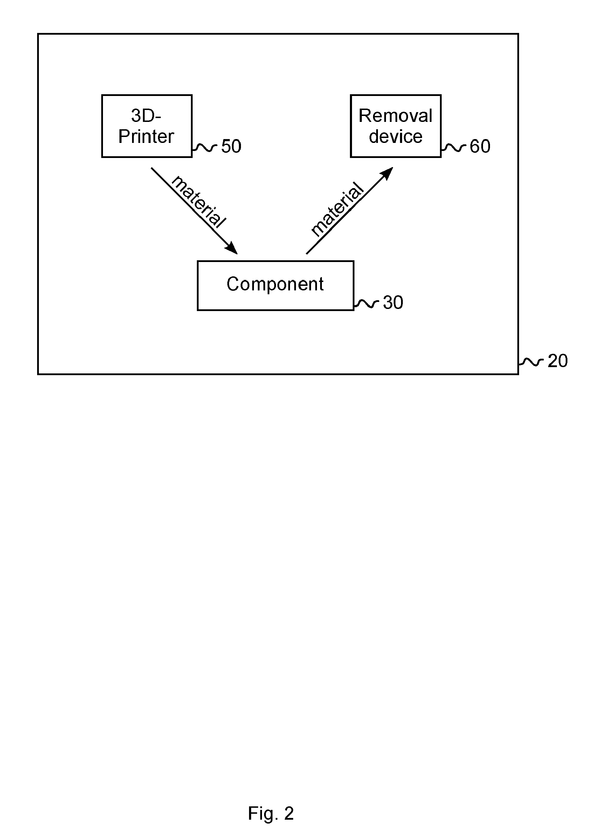

Fig. 2 depicts an embodiment of a circuit 20. The circuit comprises a 3D printer 50 operable to use a material to adjust a component 30 after deviation of the component's property has been determined. The embodiment shown in Fig. 2 further comprises a device 60 operable to remove the material from the circuit 20 to adjust the component after deviation of the component's property has been determined.

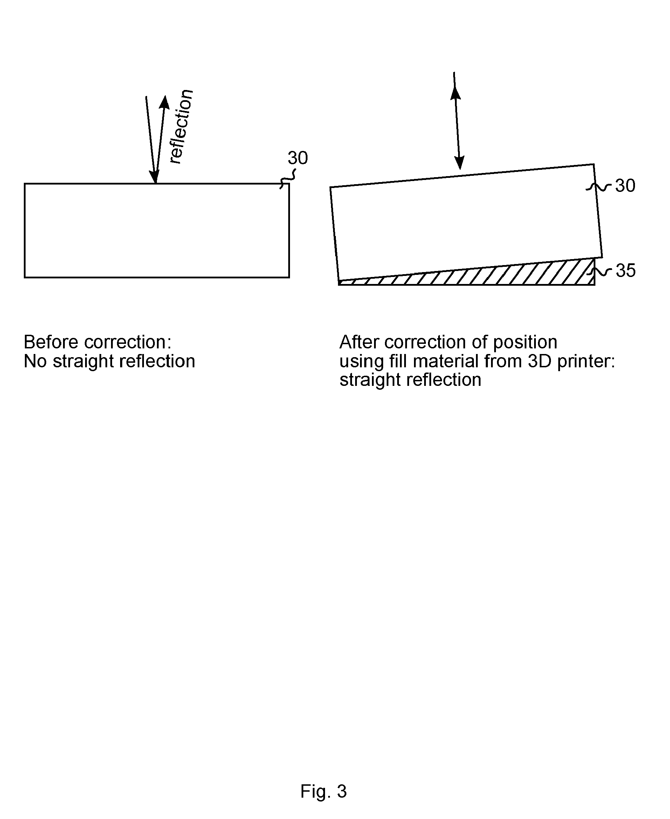

Fig. 3 shows an embodiment of an adjustment in a manufacturing process. Fig. 3 shows a component 30 on the left-hand side, which can for example be an optical component such as a reflector. As indicated by the arrows representing incoming and reflected electromagnetic waves in a ray representation, e.g. light rays, there is a dis-adjustment of the component 30. In the embodiment depicted in Fig. 3 it is assumed that a direct reflection, i.e. the reflective ray has the same direction or angle as the incoming ray, is desired. Hence, additional material 35 is brought to the component which is shown on the right-hand side of Fig. 3, such that the desired reflection angles are achieved. Fig. 3 shows on the right-hand side the corrected orientation of the component 30 using the material 35 from the 3D printer. With respect to Fig. 1 the embodiment of Fig. 3 shows that the 3D printing 12 can comprise adjusting a geometrical orientation of the component 30. In other embodiments, as will be detailed below, surface properties of the component 20 can be adjusted, thereby also adjusting reflection properties of the component 30. With respect to Fig. 2 the embodiment of Fig. 3 shows that the component can be a reflector and the material 35 can be a filling material to adjust the orientation of the reflector. From this perspective, the component 30 can be a mechanical component, the material 35 can be a filling material and the fitting of the mechanical component 30 therewith the reflection angle, is adjusted.

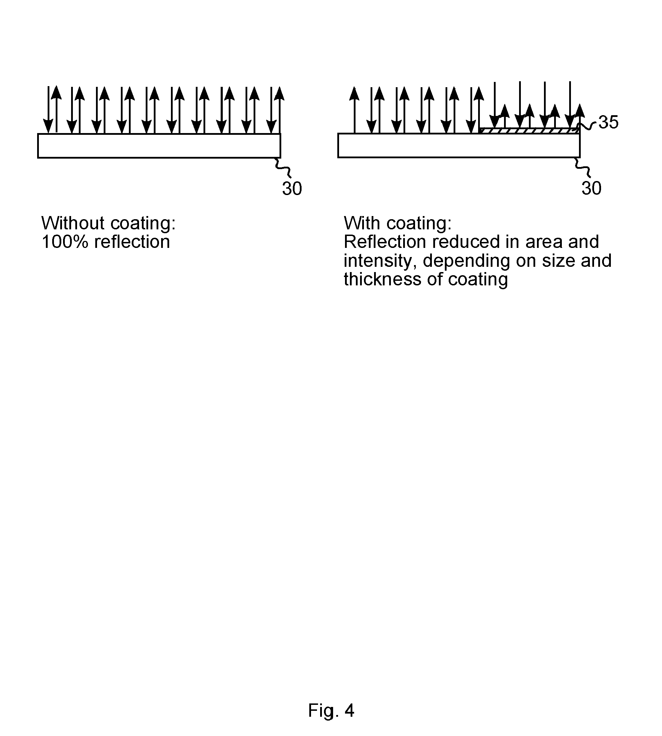

Fig. 4 illustrates an embodiment of a component 30 where a surface is adjusted using a coating or covering material 35. In Fig. 4 on the left-hand side the component 30 is depicted without the coating, yielding 100 % reflection, which is indicated by the respective arrows. On the right-hand side of Fig. 4 the coating or covering layer of printing material 35 is depicted, which was applied to the component 30 using the 3D printer. With the coating, the reflection is reduced in a certain area, in Fig. 4 on the right-hand side of the component 30, and the intensity is decreased. Depending on the size and thickness of the coating or covering material 35, the reflection can be further adjusted. With respect to Fig. 1, the 3D printing 12 comprises adjusting the reflection properties of the component 30 and the adjusting comprises reducing at least partly the reflection of the component 30. In other words, the 3D printing 12 can comprise adjusting surface properties of the component 30.

Fig. 4 illustrates an embodiment where the component 30 is a reflector and the material 35 is a reflecting or a covering material. The reflection property of the component 30 is adjusted. In another embodiment, the surface of the component ages and does not reflect as well anymore. In such an embodiment a material 35 can be used, which reflects better than the actual surface of the component 30.

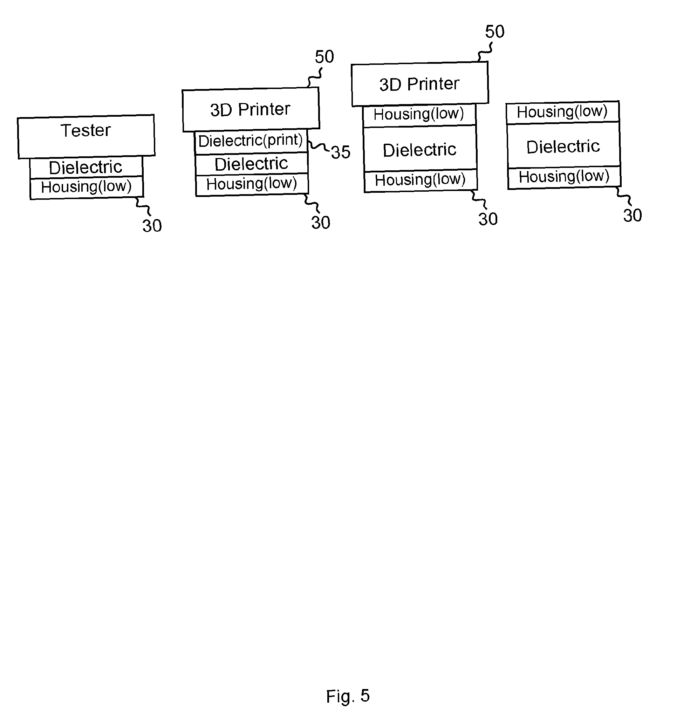

Fig. 5 illustrates another embodiment of a manufacturing process, where on the very left-hand side the component 30 is shown with a housing and dielectric. In the present embodiment it is assumed that the adjustable component 30 is a capacitor comprising the dielectric. The material 35 corresponds to additional dielectric influencing the capacity of the capacitor. In a second step, shown in the second Figure from the left in Fig. 5, the 3D printer 50 adds the additional material 35. In the present embodiment it is shown in the second step from the right in Fig. 5 that the 3D printer 50 is further operable to print another housing layer onto the component 30. In embodiments, the 3D printer 50 can therefore be operable to print or dispense different materials. On the very right hand side of the Fig. 5 the component 30 is shown with the enhanced layer of dielectric and the complete housing. With respect to Fig. 1 the method can further comprise 3D printing 12 a housing for the component 30. That is to say, the component 30 is a capacitor, a first material 35 is a dielectric, a second material is a housing material and the capacity of the capacitor is adjusted.

Fig. 5 shows on the very left-hand side a tester, which corresponds to means for determining deviations on the capacitor. In embodiments said means for determining deviations can be adapted to determine deviations on radio frequency components or on optical components after the circuit 20 has been in an operating state. That is to say, the tester may be used to determine the deviations of the radio frequency components of a base station transceiver to detect or determine or measure aging effects. In Fig. 5 the modification of an RF component performance during the product assembly and test is illustrated. It is assumed that the component 30 is mounted on a printed circuit board. A printed circuit board with RF components may need board-specific, one-time fine-tuning of a component containing dielectric during final manufacturing steps. In so far the component 30 may be any RF component comprising a dielectric. In the process, an initial measurement of the electrical characteristics of the component 30 is used to achieve information on the needed dielectric. This step can be followed by one or several iterations where additional dielectric 35 is built up by the 3D printer 50 until the desired characteristics of the component 30 have been achieved.

For example, a capacitor is mounted on the printed circuit board. It consists of the lower part of the housing and an initial amount of dielectric. The upper part of the housing for the measurement process is replaced by an automatic tester, i.e. means for determining, with an integrated 3D printer 50. The tester performs initial measurements which result in missing dielectric. The 3D printer is used to apply some dielectric material and measurements are repeated. Once the desired result is achieved the 3D printer 50 uses housing material, which can be different from the die-electric, to finish the capacitor. The housing material and also other materials can be dispensed by the 3D printer 50. In some embodiments several materials like non-conductors and conductors may be printed.

In yet another embodiment, modifications on an RF component's performance during product operation may be carried out. Irreversible modifications of RF characteristics may occur during operation of RF components, for example, by aging. It may be possible to reverse these modifications by modifying the environment in which they are used. On a printed circuit board, conducting parts with radio frequency characteristics may be modified by adding additional conducting material 35 using a miniaturized 3D printer 50. As well radio frequency-absorbing material can be used to control unwanted interferences caused by aging components.

Sensors may be integrated to obtain measurement data such that algorithms can control an integrated 3D printer 50 for corrective actions. The sensors to obtain the measurement data may be part of the above means for determining and they can be installed either on-board or externally to the circuit 20. The printer 50 usually may be inactive and in a special parking position to be protected against environmental influences and damages, somewhat similar to parking positions of computer hard disks. Once RF modifications are desired, the printer 50 may become active. Printing material may be kept in according containers or cartridges.

In further embodiments, the circuit 20 may comprise means for determining a temperature of the component 30. The circuit 20 can be further operable to adjust a component 30 based on the temperature. In other words, the circuit 20 may be operable to control the printer 50 in a way that the adjustments of the component 30 are carried out at certain temperature levels. Depending on the printer material and the component property that is to be adjusted, other temperatures may be preferred. For example, if a mechanical gap is to be filled with filling material, a rather low temperature may be used, since the gap is then rather small to avoid tensions when the temperature rises again. Obviously, in the other embodiments, the opposite may be the case.

In yet another embodiment RF components are adjusted. For example, if two RF components are assumed which have a spacing of three wavelengths, i.e. 3 λ. Due to aging effects, the distance between these two components changed, for example it is now 3.1 wavelengths. The 3D printer 50 can be used to print conducting material to one of the RF components, so to adjust the distance between them back to 3 wavelengths. In yet another embodiment, the distance may become smaller due to the aging effects, the 3D printer 50 may then be used to further decrease the distance to an integer number of wavelengths, i.e. to 2 wavelengths.

The embodiment shows that the material which is used can be manifold. Embodiments may use conducting, non-conducting, semi-conducting, dielectric, ferromagnetic, ferrimagnetic, plastic, etc. material. Moreover, some of these materials may be liquid and may need to be cured or hardened after being dispensed. In embodiments the step of curing or hardening the material can be applied, the respective circuit 20 may comprise means for curing or hardening the material. The curing or hardening may be achieved for example by using ultraviolet light, hence, the means for curing or hardening may be implemented as an ultraviolet light. In other embodiments, other curing or hardening methods may be used, for example X-raying, application of another material, etc.

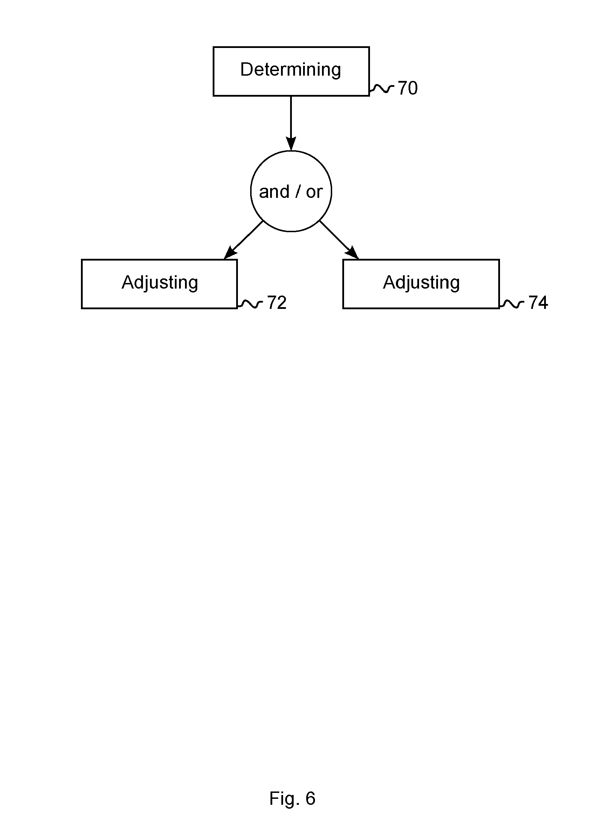

Fig. 6 illustrates a block diagram of an embodiment of a method for adjusting a deviation of a component of a circuit 20. The method comprises a step of determining 70 a deviation of the component. The method further comprises a step of adjusting the component by adding material 35 using a 3D printer 50 and/or a step of adjusting 74 the component by removing material 35 using a removal device 60.

In further embodiments, a computer program may be used having a program code for performing one of the above methods when a computer program is executed on a computer or a processor.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as magnetic disks and magnetic tapes, hard drives, or optically readable digital data storage media. The embodiments are also intended to cover computers programmed to perform said steps of the above-described methods or (field) programmable logic arrays ((F)PLAs) or (field) programmable gate arrays ((F)PGAs), programmed to perform said steps of the above-described methods.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing or to perform a certain function, respectively. Hence, a "means for s.th." may as well be understood as a "means being adapted or suited for s.th.". A means being adapted for performing a certain function does, hence, not imply that such means necessarily is performing said function (at a given time instant).

The functions of the various elements shown in the Figures, including any functional blocks labeled as "means", "means for determining", "means for curing", "means for hardening", etc., may be provided through the use of dedicated hardware, such as "a determiner", "a curer", "a hardener", etc. as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. Method for manufacturing a circuit (20), comprising
mounting (10) of an adjustable component (30) of the circuit (20); and
3D-printing (12) a material (35) to adjust the component.

2. Method of claim 1 further comprising
measuring (14) the adjustable component (30) in the circuit (20) to obtain a measurement result, and adjusting the component (30) based on the measurement result using the 3D-printing (12).

3. Method of claim 1, wherein the mounting (10) of the adjustable component (30) corresponds to mounting the adjustable component (30) on a printed circuit board.

4. Method of claim 1, wherein the adjustable component (30) is a capacitor comprising a dielectric and wherein the material (35) corresponds to additional dielectric influencing the capacity of the capacitor, and/or wherein the method further comprises 3D-printing (12) a housing for the component (30).

5. Method of claim 1, wherein the 3D-printing (12) comprises adjusting a geometrical orientation of the component (30) or adjusting surface properties of the component (30) and/or wherein the method further comprise removing (16) material (35) to adjust the component (30).

6. Method of claim 5, wherein the 3D-printing (12) comprises adjusting reflection properties of the component (30) and/or wherein the adjusting comprises reducing at least partly a reflection at the component (30).

7. Circuit (20) comprising a 3D-printer (50) operable to use a material (35) to adjust a component (30) after a deviation of the component's property has been determined and/or comprising a device (60) operable to remove the material (35) from the circuit (20) to adjust the component (30) after the deviation of the component's property has been determined.

8. Circuit (20) of claim 7, wherein the component (30) is a capacitor, the material (35) is a dielectric, and wherein a capacity of the capacitor is adjusted.

9. Circuit (20) of claim 7, wherein the component (30) is a reflector and the material (35) is a reflecting or a covering material, wherein a reflection property of the component (30) is adjusted.

10. Circuit (20) of claim 7, comprising means for determining a deviation on a radio frequency component or on an optical component after the circuit (20) has been in an operating state.

11. Circuit (20) of claim 7, wherein the component (30) is a mechanical component, the material (35) is a filling material, and wherein a fitting of the mechanical component (30) is adjusted.

12. Circuit (20) of claim 7, further comprising means for determining a temperature of the component (30), wherein the circuit is (20) further operable to adjust the component (30) based on the temperature.

13. Base station transceiver of a mobile communication system with a circuit (20) of claim 7.

14. Method for adjusting a deviation of a component of a circuit (20), comprising determining (70) the deviation of the component;
adjusting (72) the component by adding material (35) using a 3D-printer (50); and/or
adjusting (74) the component by removing material (35) using a removal device (60).

15. A computer program having a program code for performing the method of claim 14, when the computer program is executed on a computer or processor.

## Amended claims

### Amended claims in accordance with Rule 137(2) EPC.

**1.** Method for adjusting a deviation of a component of a circuit (20), comprising
determining (70) the deviation of the component; and
adjusting (72) the component by adding material (35) using a 3D-printer (50).

**2.** Method of claim 1 for manufacturing a circuit (20), further comprising
mounting (10) of an adjustable component (30) of the circuit (20); and
3D-printing (12) a material (35) to adjust the component.

**3.** Method of claim 2 further comprising
measuring (14) the adjustable component (30) in the circuit (20) to obtain a measurement result, and adjusting the component (30) based on the measurement result using the 3D-printing (12) and/or wherein the mounting (10) of the adjustable component (30) corresponds to mounting the adjustable component (30) on a printed circuit board.

**4.** Method of claim 2, wherein the adjustable component (30) is a capacitor comprising a dielectric and wherein the material (35) corresponds to additional dielectric influencing the capacity of the capacitor, and/or wherein the method further comprises 3D-printing (12) a housing for the component (30).

**5.** Method of claim 2, wherein the 3D-printing (12) comprises adjusting a geometrical orientation of the component (30) or adjusting surface properties of the component (30), wherein the method further comprises removing (16) material (35) to adjust the component (30), and/or wherein the method further comprises adjusting (74) the component by removing material (35) using a removal device (60).

**6.** Method of claim 5, wherein the 3D-printing (12) comprises adjusting reflection properties of the component (30) and/or wherein the adjusting comprises reducing at least partly a reflection at the component (30).

**7.** Circuit (20) comprising a 3D-printer (50) operable to use a material (35) to adjust a component (30) after a deviation of a component's property has been determined.

**8.** Circuit (20) of claim 7, comprising a device (60) operable to remove the material (35) from the circuit (20) to adjust the component (30) after the deviation of the component's property has been determined.

**9.** Circuit (20) of claim 7, wherein the component (30) is a capacitor, the material (35) is a dielectric, and wherein a capacity of the capacitor is adjusted.

**10.** Circuit (20) of claim 7, wherein the component (30) is a reflector and the material (35) is a reflecting or a covering material, wherein a reflection property of the component (30) is adjusted.

**11.** Circuit (20) of claim 7, comprising means for determining a deviation on a radio frequency component or on an optical component after the circuit (20) has been in an operating state.

**12.** Circuit (20) of claim 7, wherein the component (30) is a mechanical component, the material (35) is a filling material, and wherein a fitting of the mechanical component (30) is adjusted.

**13.** Circuit (20) of claim 7, further comprising means for determining a temperature of the component (30), wherein the circuit is (20) further operable to adjust the component (30) based on the temperature.

**14.** Base station transceiver of a mobile communication system with a circuit (20) of claim 7.

**15.** A computer program having a program code for performing the method of claim 14, when the computer program is executed on a computer or processor.
